# EUROPEAN PATENT APPLICATION

(11) **EP 2 157 300 A1**
(43) Date of publication of application: **24.02.2010**
(21) Application number: 09168123.9
(22) Date of filing: 18.08.2009
(51) Int. Cl.: F02D 11/10, F02D 11/02, B62K 23/06, F02D 9/02

(54) **Drive-by-wire throttle control apparatus and method of forming the same**

(30) Priority: 20.08.2008 US 194760
(71) Applicant: Honeywell International Inc., Morristown, NJ 07962-2245 (US)
(72) Inventor: Chandran, Anand, Springfield, IL 62711 (US); Cable, Al, Springfield, IL 62712 (US)
(74) Representative: Buckley, Guy Julian

(57) **Abstract**

A drive-by-wire throttle control apparatus and method of forming the same. The apparatus includes a Hall-effect magnetic sensor. A thumb lever can be assembled into a mounting bracket inside a cylindrical hole, which can rotate to a desired angle. The thumb lever can be mechanically connected to a magnet holder, which includes a magnet, utilizing a key-slot mechanism. The magnet holder can be placed inside a housing that allows the magnet holder to rotate and restrict other movements. When the thumb lever rotates, the lever rotates the magnet holder, which in turn detects the position of the throttle utilizing a varying voltage output from an associated Hall-effect chip. A signal can be generated based on the sensed position.

## Description

### TECHNICAL FIELD

Embodiments are generally related to Hall-effect components. Embodiments are also related to Hall-effect magnetic sensors. Embodiments are additionally related to throttle control devices.

### BACKGROUND OF THE INVENTION

A throttle controls the flow of air, or air and fuel, which can be inducted into an internal combustion engine to control the power produced by the engine. Engine power defines the speed of the engine or vehicle to which it is attached, under a given load condition, and thus, reliable control of the throttle setting is important. Vehicles are known to utilize throttle controls that are mechanical and electrical in nature. For example, an off-road vehicle, such as an ATV (All Terrain Vehicle) or a snowmobile, operates with a small gasoline powered engine. To operate such an engine, the operator activates a thumb lever or twist grip mounted on a handlebar that controls the engine throttle.

The thumb lever or throttle is usually mounted to the right handlebar in order to control engine throttle. As the rider grips this handlebar, the rider's thumb operates the throttle by pushing the throttle against the handle bar and holding it in place. The throttle is designed to provide a range of speeds as the throttle is depressed. If the throttle is held fully open, the highest speeds can be attained. However, holding the throttle between "off" and "full" produces an intermediate level of speed. To keep the throttle from "sticking" in the open position, a spring is typically utilized to force the throttle back to the "off" position if the throttle is released.

In the majority of prior art throttle configurations, a direct mechanical linkage controls the throttle, typically in the form of a cable running from the thumb lever or twist grip to a throttle mechanism associated with the engine. Such throttle actuation is mechanical in nature and hence, the cable is subject to a great deal of wear and tear. Although mechanical linkages are simple and intuitive, such components cannot readily be adapted to electronically control an engine such as may be desired with sophisticated emissions reduction systems or for other features such as, for example, automatic vehicle speed control.

Drive-by-wire throttle control can be utilized to eliminate mechanical linkage between the thumb lever and the throttle mechanism and to reduce the number of moving parts and hence the weight of the engine. In general, the drive-by-wire throttle control mechanism utilizes Hall-effect chip associated with a magnet as a position sensor for the throttle control. The distance between the Hall-effect chip and the magnet should be maintained constant in all conditions for precise detection of the throttle position. Such an approach becomes difficult with prior art designs as the throttle control is typically subject to a great deal of vibration, movement and external forces.

Based on the foregoing, it is believed that a need exists for an improved drive-by-wire throttle control apparatus associated with a Hall-effect magnetic sensor. A need also exists for an improved mechanical design for effective position sensing as described in greater detail herein.

### BRIEF SUMMARY

The following summary is provided to facilitate an understanding of some of the innovative features unique to the embodiments disclosed and is not intended to be a full description. A full appreciation of the various aspects of the embodiments can be gained by taking the entire specification, claims, drawings, and abstract as a whole.

It is, therefore, one aspect of the present invention to provide for an improved drive-by-wire throttle control apparatus.

It is a further aspect of the present invention to provide for an improved drive-by-wire throttle control apparatus that includes the use of a magnetic sensor such as, for example, a Hall-effect magnetic sensor.

It is another aspect of the present invention to provide for an improved mechanical design for maintaining a constant distance between a Hall-effect chip and a magnet for precise detection of throttle position.

It is yet a further aspect of the present invention to provide for a method for configuring an improved drive-by-wire throttle control apparatus.

The aforementioned aspects and other objectives and advantages can now be achieved as described herein. A drive-by-wire throttle control apparatus and method for forming the same is disclosed, which includes the use of a Hall-effect magnetic sensor. A thumb lever can be assembled into a mounting bracket within a cylindrical hole, which can rotate to a desired angle. The thumb lever can be mechanically connected to a magnet holder, which includes a magnet utilizing, for example, a key-slot mechanism. The magnet holder can be placed inside a housing in order to permit the magnet holder to rotate and restrict the movement of other components. When the thumb lever rotates, the lever also rotates the magnet holder, which in turn detects the position of the throttle utilizing a varying voltage output from an associated Hall-effect chip. A signal can be generated based on the sensed position. The signal can be electrically transmitted to an ECU (Electronic Control Unit) utilizing electrical wires in the form of, for example, a varying voltage, which in turn controls the throttle of a vehicle.

The magnet is generally in magnetic communication with the Hall-effect magnetic sensor. The Hall-effect magnetic sensor can be utilized for throttle control in, for example, off road vehicles, thereby eliminating the need for cables and other mechanical parts such as those found in ATV's and snowmobiles. Such a mechanical design allows the magnet to rotate without allowing any other type of movement and is not subject to vibrations and other forces that might distort the sensing capability. Hence, the distance between the Hall-effect chip and the magnet can be maintained constant in all conditions and the throttle position can be precisely detected. The disclosed embodiments can be customized to any type of rotary sensor that possesses similar automobile thumb lever applications.

### BRIEF DESCRIPTION OF THE DRAWINGS

The accompanying figures, in which like reference numerals refer to identical or functionally-similar elements throughout the separate views and which are incorporated in and form a part of the specification, further illustrate the embodiments and, together with the detailed description, serve to explain the embodiments disclosed herein.

FIG. 1 illustrates a perspective view of a drive-by-wire throttle control apparatus associated with a Hall-effect magnetic sensor, which can be implemented in accordance with a preferred embodiment;

FIG. 2 illustrates a cross sectional view of the drive-by-wire throttle control apparatus with a magnet holder, which can be implemented in accordance with a preferred embodiment; and

FIG. 3 illustrates a detailed flow chart of operation illustrating logical operational steps of a method for designing the drive-by-wire throttle control apparatus, which can be implemented in accordance with a preferred embodiment.

### DETAILED DESCRIPTION

The particular values and configurations discussed in these non-limiting examples can be varied and are cited merely to illustrate at least one embodiment and are not intended to limit the scope thereof.

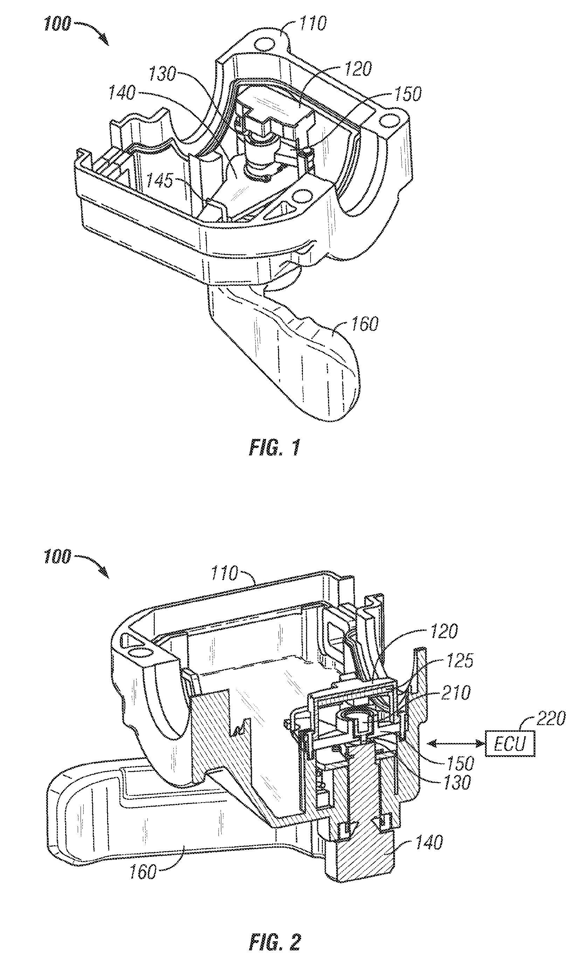

FIG. 1 illustrates a perspective view of a drive-by-wire throttle control apparatus 100 associated with a Hall-effect magnetic sensor 120, in accordance with a preferred embodiment. The Hall-effect magnetic sensor 120 generally includes a PCB assembly with a Hall chip 125 and a magnet holder 130 that includes a magnet 210, as shown in FIG. 2. The Hall-effect magnetic sensor 120 is a type of magnetic sensor that utilizes the Hall-effect to detect a magnetic field. The Hall-effect occurs when a current-carrying conductor is placed into a magnetic field generated by the magnet 210. A voltage can be generated perpendicular to both the current and the field. The voltage is proportional to the strength of the magnetic field to which it is exposed. A thumb lever 140 can be mechanically connected to the magnet holder 130 utilizing a key-slot mechanism. The thumb lever 140 can be assembled into a mounting bracket 110 inside a cylindrical hole (not shown), which can rotate to a desired angle. The magnet holder 130 houses the magnet 210 that is magnetized diagonally.

The Hall chip 125 comprises a Hall element and it is typically composed of a semiconductor material. The thumb lever 140 associated with a handle 160 has a long, extended portion. The length of the handle 160 can be adjusted as well, depending on the preferences of different riders. The thumb lever 140 can be mounted on the handle bar 160 utilizing the torsion spring 145, which controls throttle of the engine. The magnet holder 130 can be placed inside a housing 150 that allows the magnet holder 130 to rotate and restricts all the other movements like up down or tilting. Such a restriction to movements other than rotation is critical in sensing the accuracy of thumb lever position.

FIG. 2 illustrates a cross sectional view of the drive-by-wire throttle control apparatus 100 with the magnet holder 130, which can be implemented in accordance with a preferred embodiment. Note that in FIGS. 1-3 identical or similar parts or elements are generally indicated by identical reference numerals. A sensed member can be provided, which is preferably a magnet 210 that possesses a magnetic field associated with the thumb lever 140 and the mounting bracket 110. Preferably, the Hall-effect sensor chip 125 can be configured to detect the magnetic field, which in turn senses the position of the thumb lever 140. In a preferred embodiment, Hall-effect magnetic sensor 120 can be mounted to the mounting bracket 110 and is in contactless association with the thumb lever 140.

The magnet 210 can be placed in the magnetic holder 130 with a bond and filled with an epoxy. The extended portion of the handle 160 terminates at the mounting bracket 110. The mounting bracket 110 is preferably operably designed and configured to mount the thumb lever 140 to the handle bar 160. The thumb lever 140 is preferably received within the mounting bracket 110 and preferably coaxial therewith, although the thumb lever 140 can be received in other positions and/or orientations. The preferred thumb lever 140 generally constitutes a twist throttle, which receives the handle bar 160 for rotation thereabout. The mounting bracket 110 comprises a curved body, as shown. In the preferred embodiment, the thumb lever 140 can be molded in one piece from plastic or similar materials. Of course, it can be made of metal as well. Note that the embodiments discussed herein should not be construed in any limited sense. It can be appreciated, however, that such embodiments reveals details of structure of a preferred form necessary for a better understanding of the invention and may be subject to change by skilled persons within the scope of the invention without departing from the concept thereof.

The handle 160 can be attached to the PCB assembly with the Hall-effect sensor chip 125 through the magnet 210 associated with the magnet holder 130. Drive-by-wire technology in the automotive industry replaces the traditional mechanical and hydraulic control systems with electronic control systems. The positioning of position sensing magnet 210 is such that magnetic flux lines radiate parallel to the axis of rotation of the thumb lever 140. The rotation of the thumb lever 140 effectuates the angular motion of the magnetic holder 130 about the throttle valve axis. The magnetic holder 130 associated with the magnet 210 rotates when the thumb lever 140 rotates, which in turn senses the position of the throttle utilizing the varying voltage from the Hall-effect chip 125. Note that such a design mainly helps in rotating the magnet 210 and all the other possible movements such as, for example, up-down, tilting, etc can be restricted. Hence, the distance between the Hall-Effect chip 125 and the magnet 210 can be maintained constant in all conditions for precise detection of throttle position.

The Hall-effect magnetic sensor 120 is a magnetic sensor that is responsive to variations in the magnetic field generated by the angular motion of position sensing magnet 210. The varying magnetic field sensed by the Hall-effect magnetic sensor 120 is sent to an ECU 220, which is converted to a voltage value that is used to control the throttle of a vehicle. The ECU 220 determines the required throttle position by calculations from data measured by other sensors such as an accelerator pedal position sensor, engine speed sensor, vehicle speed sensor etc. The drive-by-wire technology eliminates the need for a throttle cable such as in ATV's and snowmobiles. The Hall-effect magnetic sensor 120 can be utilized as throttle control in off road vehicles eliminating the need of cables and other mechanical parts that is used traditionally.

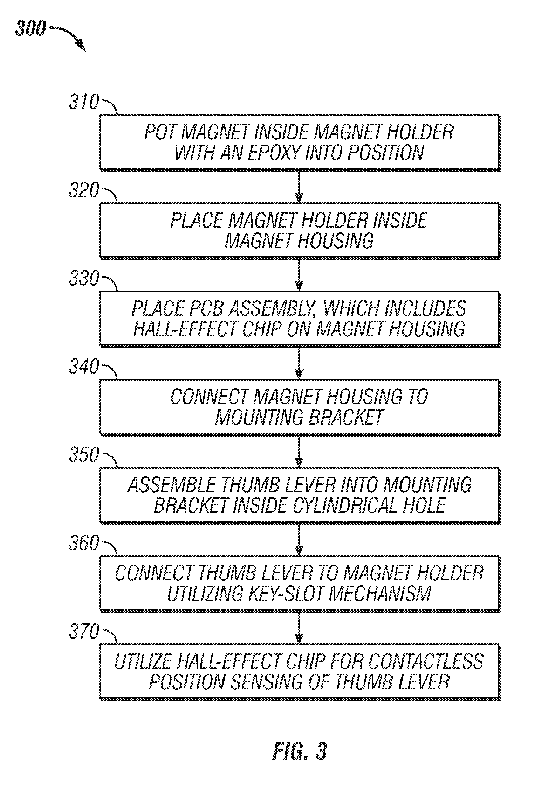

FIG. 3 illustrates a detailed flow chart of operation illustrating logical operational steps of a method 300 for designing the drive-by-wire throttle control apparatus 100, which can be implemented in accordance with a preferred embodiment. The magnet 210 can be potted into the magnet holder 130 with an epoxy into position, as depicted at block 310. The magnet holder 130 can be placed inside the magnet housing 150 where it can only rotate and restricted from other movements such as up-down, tilting etc, as illustrated at block 320. The PCB assembly, which includes the Hall-effect chip 125, can be placed on the magnet housing 150, as illustrated at block 330. The Hall-effect magnetic sensor 120 can be utilized to detect position of the thumb lever 140. The magnet housing 150 can be connected to the mounting bracket 110, as illustrated at block 340. The thumb lever 140 can be assembled into the mounting bracket 110 inside the cylindrical hole where it can rotate to a desired angle, as depicted at block 350. Thereafter, the thumb lever 140 lever can be connected to the magnet holder 130 by utilizing a key-slot mechanism, as shown at block 360.

The Hall-effect magnetic sensor 120 comprising the magnet 210 and the Hall-effect chip 125 can be utilized for position sensing of the thumb lever 140, as depicted at block 370. The Hall-effect magnetic sensor 120 can generate a varying voltage with respect to the movement of the thumb lever 140. Such a mechanical design rotates the magnet 210 without allowing any other type of movement and is not subject to vibrations and other forces that might distort the sensing capability. The distance between the Hall-effect chip 125 and the magnet 210 can be maintained constant in all conditions for precise detection of the throttle position and can withstand vibrations and other forces that might distort the sensing capability. The apparatus 100 can be customized to any type of rotary sensor that possesses similar applications of an automobile throttle lever.

It will be appreciated that variations of the above-disclosed and other features and functions, or alternatives thereof, may be desirably combined into many other different systems or applications. Also, that various presently unforeseen or unanticipated alternatives, modifications, variations or improvements therein may be subsequently made by those skilled in the art which are also intended to be encompassed by the following claims.

## Claims

1. A throttle control apparatus, comprising:
a magnet holder comprising a position sensing magnet;
a thumb lever connected to a mounting bracket at a cylindrical hole formed in said mounting bracket, wherein said thumb lever is mechanically connected to said magnet holder, wherein said magnet holder is located within a housing that permits said magnet holder to rotate while restricting the movement of other components; and
a magnetic position sensor in magnetic communication with said position sensing magnet and in contactless association with said thumb lever, wherein said magnetic holder rotates as said thumb lever rotates in order to thereby enable said magnetic position sensor to detect a position of said thumb lever on a handle bar and provide in response a varying voltage output.

2. The apparatus of claim 1 further comprising: an electronic control unit associated with said magnetic position sensor that generates a signal in a form of said varying voltage output, based on a sensed position of said thumb lever in order to control a throttle of a vehicle and eliminate a need for a throttle cable.

3. The apparatus of claim 1 wherein said thumb lever is connected to said magnet holder utilizing a key-slot mechanism.

4. The apparatus of claim 1 wherein said position sensing magnet is magnetized diagonally.

5. The apparatus of claim 1 wherein said position sensing magnet is placed inside said magnet housing via a bonder and filled with an epoxy.

6. The apparatus of claim 1 wherein said magnetic position sensor and said position sensing magnet are maintained at a constant distance apart across a variety of operating and environmental conditions.

7. The apparatus of claim 1 wherein said magnetic position sensor comprises a Hall-effect sensor.

8. A throttle control method, comprising:
configuring a magnet holder to include a position sensing magnet;
connecting a thumb lever to a mounting bracket at a cylindrical hole formed in said mounting bracket, wherein said thumb lever is mechanically connected to said magnet holder;
locating said magnet holder within a housing that permits said magnet holder to rotate and restricts the movement of other components; and
positioning a magnetic position sensor to magnetically communicate with said position sensing magnet without contacting said thumb lever, wherein said magnetic holder rotates as said thumb lever rotates such that said magnetic position sensor detects a position of said thumb lever on a handle bar and provides in response a varying voltage output.

9. The method of claim 8 further comprising associating an electronic control unit with said magnetic position sensor that generates a signal in a form of said varying voltage output, based on a sensed position of said thumb lever in order to control a throttle of a vehicle and eliminate a need for a throttle cable.

10. The method of claim 8 connecting said thumb lever to said magnet holder utilizing a key-slot mechanism.

11. The method of claim 8 further comprising diagonally magnetizing said position sensing magnet.

12. The method of claim 8 further comprising placing said position sensing magnet inside said magnet housing via a bonder and filled with an epoxy.

13. The method of claim 8 further comprising maintaining said magnetic position sensor and said position sensing magnet at a constant distance across a variety of operating and environmental conditions.

14. The method of claim 8 further comprising configuring said magnetic position sensor to comprise a Hall-effect sensor.
